(19) Europäisches Patentamt / European Patent Office / Office européen des brevets

(11) **EP 3 640 651 B1**

(12) **EUROPÄISCHE PATENTSCHRIFT**

(45) Veröffentlichungstag und Bekanntmachung des Hinweises auf die Patenterteilung:
**01.03.2023 Patentblatt 2023/09**

(21) Anmeldenummer: **19202988.2**

(22) Anmeldetag: **14.10.2019**

(51) Internationale Patentklassifikation (IPC):
**G01R 1/20** (2006.01)    **G01R 31/00** (2006.01)
**G01R 27/08** (2006.01)

(52) Gemeinsame Patentklassifikation (CPC):
**G01R 1/203; G01R 27/08; G01R 31/006;**
G01R 31/364

(54) **VERFAHREN ZUM BETRIEB EINES STROMSENSORS UND STROMSENSOR**

OPERATION METHOD OF A CURRENT SENSOR AND CURRENT SENSOR

PROCÉDÉ DE FONCTIONNEMENT D'UN CAPTEUR DE COURANT ET CAPTEUR DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.10.2018 DE 102018217605**

(43) Veröffentlichungstag der Anmeldung:
**22.04.2020 Patentblatt 2020/17**

(73) Patentinhaber: **Continental Automotive Technologies GmbH**
**30165 Hannover (DE)**

(72) Erfinder:
• **Schramme, Martin**
**60488 Frankfurt am Main (DE)**
• **Geiger, Martin**
**60488 Frankfurt am Main (DE)**

(74) Vertreter: **Continental Corporation**
**c/o Continental Teves AG & Co. OHG**
**Intellectual Property**
**Guerickestraße 7**
**60488 Frankfurt a. Main (DE)**

(56) Entgegenhaltungen:
**EP-A2- 2 546 664    DE-A1-102017 203 535**

EP 3 640 651 B1

**Beschreibung**

Die Erfindung betrifft ein Verfahren zum Betrieb eines Stromsensors sowie einen Stromsensor.

In vielen Anwendungen, insbesondere im Fahrzeugbereich, ist es erforderlich, die auftretenden Ströme sehr exakt zu ermitteln bzw. zu messen. Aus dem Stand der Technik sind beispielsweise Verfahren sowie Sensoren bekannt, bei welchen die Stromstärke über den Spannungsabfall über ein im Strompfad angeordneten Messwiderstand ermittelt wird. Hierzu ist es erforderlich, dass der elektrische Widerstand des Messwiderstands sehr genau bekannt ist. Im Fahrzeugbereich ist es des Weiteren erforderlich, dass unabhängig von der Temperatur oder äußeren Einflüssen über die gesamte Lebensdauer des Fahrzeugs bzw. des Sensors eine möglichst exakte Messung sichergestellt ist.

Bisher werden daher für den Messwiderstand spezielle Legierungen verwendet, beispielsweise eine Kupfer-Nickel-Mangan-Legierung, die sowohl eine geringe zeitliche Veränderung des elektrischen Widerstandes wie auch eine geringe Empfindlichkeit bei Temperaturänderungen aufweist.

Diese Legierungen sind aber sehr teuer. Des Weiteren ist die Verarbeitung dieser Materialien sehr aufwändig, da diese mit dem Material des übrigen Stromsensors verbunden werden müssen.

Um die Genauigkeit von Stromsensoren mit Messwiderständen, insbesondere mit Messwiderständen, die eine größere Temperaturabhängigkeit oder Alterungsdrift aufweisen, zu verbessern, sind aus dem Stand der Technik Stromsensoren bekannt, die während des Betriebes ständig nachkalibriert werden. Bei diesen Stromsensoren wird über die gesamte Lebensdauer des Stromsensors der elektrische Widerstand des Messwiderstandes oder ein Korrekturwert für den elektrischen Widerstand des Messwiderstandes bestimmt, um temperatur- oder alterungsbedingte Änderungen des elektrischen Widerstandes des Messwiderstandes zu kompensieren.

Bei einem bekannten Verfahren wird ein hochpräziser Referenzwiderstand parallel zum Messwiderstand angeordnet und kurzzeitig ein Teil des Laststromes über den Referenzwiderstand geleitet. Der Spannungsabfall am Messwiderstand sinkt entsprechend dem abgezweigten Stromimpuls. Die Höhe dieses Stromimpulses wird am Referenzwiderstand bestimmt. Aus dem Verhältnis des Absinkens des Spannungsabfalls am Messwiderstand und dem am Referenzwiderstand bestimmten Stromimpuls kann der elektrische Widerstand des Messwiderstandes oder einen Korrekturwert für den elektrischen Widerstand des Messwiderstandes berechnet werden.

Um den elektrischen Widerstand des Messwiderstandes genau bestimmen zu können, ist es aber erforderlich, dass zum Zeitpunkt der Bestimmung des elektrischen Widerstandes ein möglichst konstanter Laststrom anliegt. Verändert sich der Laststrom vor oder während ein Teil des Laststroms über den Referenzwiderstand geleitet wird, kann dies die Genauigkeit der Bestimmung des Stromimpulses über den Referenzwiderstand und somit des elektrischen Widerstandes des Messwiderstandes beeinflussen.

Aus EP 2 546 664 A2 ist ein Verfahren zur Überprüfung einer Messanordnung zur Spannungsbestimmung bekannt.

Aufgabe der Erfindung ist es, ein Verfahren zum Betrieb eines Stromsensors bereitzustellen, das eine genauere Messung des Laststroms ermöglicht. Aufgabe der Erfindung ist es des Weiteren, einen Stromsensor bereitzustellen, der eine genauere Bestimmung des Laststroms ermöglicht.

Definiert ist die Erfindung durch die Merkmale der unabhängigen Ansprüche 1 und 9.

Zur Lösung der Aufgabe ist ein Verfahren zum Betrieb eines Stromsensors vorgesehen, der einen ersten Messwiderstand, einen zweiten Messwiderstand sowie einen Referenzwiderstand aufweist, wobei der erste Messwiderstand und der zweite Messwiderstand in Reihe zwischen einem ersten Anschluss und einem zweiten Anschluss des Stromsensors angeordnet sind, und wobei der Referenzwiderstand in einem ersten Messzustand vom ersten Messwiderstand und vom zweiten Messwiderstand elektrisch getrennt ist und der Referenzwiderstand in einem zweiten Messzustand elektrisch parallel zum ersten Messwiderstand geschaltet ist. Das Verfahren weist die folgenden Schritte auf:

a) im ersten Messzustand Ermitteln des Spannungsabfalls am ersten Messwiderstand und des Spannungsabfalls am zweiten Messwiderstand und Bestimmen des Verhältnisses des Spannungsabfalls am ersten Messwiderstand und des Spannungsabfalls am zweiten Messwiderstand,

b) im zweiten Messzustand Ermitteln des Spannungsabfalls am ersten Messwiderstand, des Spannungsabfalls am zweiten Messwiderstand sowie des Spannungsabfalls am Referenzwiderstand und Bestimmen des elektrischen Widerstandes des ersten Messwiderstandes und Bestimmen des elektrischen Widerstandes des zweiten Messwiderstandes aus den ermittelten Spannungsabfällen, dem elektrischen Widerstand des Referenzwiderstandes und dem im ersten Messzustand bestimmten Verhältnis der Spannungsabfälle des ersten Messwiderstandes und des zweiten Messwiderstandes.

Im Schritt a) wird zunächst im ersten Messzustand das Verhältnis der elektrischen Widerstände des ersten und des zweiten Messwiderstandes ermittelt. Hierzu ist es nicht erforderlich, den elektrischen Widerstand des ersten und/oder des zweiten Messwiderstandes zu kennen. Da die Messwiderstände elektrisch in Reihe angeordnet sind, wirken sich zudem Stromschwankungen in gleichem Masse auf die Spannungsabfälle an beiden Messwiderständen aus, so dass auch bei Auftreten von Stromschwankungen eine Bestimmung des Verhältnisses der elektrischen Widerstände der beiden Messwiderstände erfolgen kann.

Im Schritt b) wird anschließend im zweiten Messzustand der elektrische Widerstand des ersten Messwiderstandes bestimmt. In diesem Messzustand wird der Referenzwiderstand, dessen elektrischer Widerstand sehr genau bekannt ist, parallel zum ersten Widerstand geschaltet und es werden die Spannungsabfälle am ersten Messwiderstand, am zweiten Messwiderstand sowie am Referenzwiderstand gemessen. Durch den am Referenzwiderstand erfassten Spannungsabfall sowie dem bekannten elektrischen Widerstand des Referenzwiderstandes kann der Anteil des Stroms, der über den Referenzwiderstand fließt, bestimmt werden. Der durch den Stromsensor fließende Strom fließt vollständig durch den zweiten Messwiderstand und teilt sich auf die in Reihe zum zweiten Messwiderstand angeordneten Strompfade des ersten Messwiderstandes und des parallel zu diesem angeordneten Referenzwiderstandes auf. Der durch den zweiten Messwiderstand fließende Strom entspricht also den addierten Strömen durch den ersten Messwiderstand und den Referenzwiderstand. Aus dem vorab ermittelten Verhältnis der elektrischen Widerstände des ersten und des zweiten Messwiderstandes, den gemessenen Spannungsabfällen am ersten und am zweiten Messwiderstand sowie dem ermittelten Strom über den Referenzwiederstand kann der elektrische Widerstand des ersten Messwiderstandes berechnet werden.

Zur Bestimmung des elektrischen Widerstandes des ersten Messwiderstandes ist es lediglich erforderlich, die Spannungsabfälle an den Messwiderständen sowie am Referenzwiderstand zu ermitteln. Des Weiteren müssen der elektrische Widerstand des Referenzwiderstandes sowie das Verhältnis der elektrischen Widerstände des ersten und des zweiten Messwiderstandes bekannt sein. Eine Kenntnis des elektrischen Widerstandes des ersten oder des zweiten Messwiderstandes ist nicht erforderlich.

Gegebenenfalls vorhandene Schwankungen im Laststrom während des zweiten Messzustandes treten auch am zweiten Messwiderstand auf und können daher einfach erfasst werden. Diese Schwankungen können somit bei der Bestimmung des elektrischen Widerstandes des ersten Messwiderstandes berücksichtigt werden. Schwankungen im Laststrom können somit bei der Bestimmung des elektrischen Widerstandes des ersten Messwiderstandes berücksichtigt werden, so dass der elektrische Widerstand des ersten Messwiderstandes genauer bestimmt werden kann.

Nach Schritt b) wird vorzugsweise folgender Schritt durchgeführt:
c) Im ersten Messzustand Ermitteln des Spannungsabfalls am ersten Messwiderstand und des Spannungsabfalls am zweiten Messwiderstand und Bestimmen des Verhältnisses des Spannungsabfalls am ersten Messwiderstand und des Spannungsabfalls am zweiten Messwiderstand und Bestimmen des elektrischen Widerstandes des zweiten Messwiderstandes aus den ermittelten Spannungsabfällen am ersten Messwiderstand und am zweiten Messwiderstand und dem in Schritt b) ermittelten elektrischen Widerstandes des ersten Messwiderstandes.

Ist der elektrische Widerstand des ersten Messwiderstandes bekannt, kann anschließend in einem Schritt c) im ersten Messzustand der elektrische Widerstand des zweiten Messwiderstandes bestimmt werden. Hierzu wird im zweiten Messzustand der Referenzwiderstand vom ersten Messwiderstand getrennt, so dass kein Strom über den Referenzwiderstand fließt. Der Strom fließt somit vollständig über den ersten Messwiderstand und den in Reihe zu diesem angeordneten zweiten Messwiderstand.

Zur Bestimmung des elektrischen Widerstandes des zweiten Messwiderstandes wird der Spannungsabfall am ersten Messwiderstand erfasst und aus dem Spannungsabfall sowie dem bekannten bzw. dem im ersten Messzustand ermittelten elektrischen Widerstand des ersten Messwiderstandes die Stromstärke des Stroms bestimmt. Des Weiteren wird der Spannungsabfall über den zweiten Messwiderstand bestimmt. Da durch die Reihenschaltung der über beide Messwiderstände fließende Strom gleich groß sein muss, ist der über den zweiten Messwiderstand fließende Strom bekannt. Aus dem Strom sowie dem erfassten Spannungsabfall kann somit der elektrische Widerstand des zweiten Messwiderstandes bestimmt werden.

Stromschwankungen wirken sich aufgrund der Reihenschaltung der Messwiderstände auf die Erfassung der Spannungsabfälle bei beiden Messwiderständen aus. Eine am ersten Messwiderstand ermittelte Stromänderung kann somit bei der Bestimmung des elektrischen Widerstandes des zweiten Messwiderstand des berücksichtigt werden.

Durch das vorstehend beschriebene Verfahren können die elektrischen Widerstände der Messwiderstände unabhängig von Stromschwankungen sehr genau bestimmt werden. Voraussetzung ist lediglich, dass das in Schritt a) ermittelte Verhältnis der elektrischen Widerstände des ersten und des zweiten Messwiderstandes bekannt ist und sich während der Bestimmung der elektrischen Widerstände der Messwiderstände nicht ändert.

Zudem erfolgt in beiden Messzuständen eine Bestimmung der Stromstärke des durch den Stromsensor fließenden Stroms, so dass eine unterbrechungsfreie Strommessung sichergestellt ist.

Die Schritte b) und c) werden vorzugsweise wechselweise wiederholt, so dass ein ständiger Abgleich der beiden Messwiderstände bzw. der elektrischen Widerstände der Messwiderstände erfolgt. Insbesondere können durch den wechselweisen Abgleich die elektrischen Widerstände der Messwiderstand durch Iteration genauer bestimmt werden.

Vor Schritt a) kann optional der elektrische Widerstand des ersten Messwiderstandes bestimmt werden.

Das Verfahren kann beispielsweise im ersten Messzustand folgende Schritte aufweisen:

- der über den ersten Messwiderstand fließende Strom wird aus dem Spannungsabfall am ersten Messwiderstand und dem elektrischen Widerstand des ersten Messwiderstandes bestimmt und/oder
- der über den zweiten Messwiderstand fließende Strom wird aus dem Spannungsabfall am zweiten Messwiderstand und dem elektrischen Widerstand des zweiten Messwiderstandes bestimmt wird
- und anschließend wird der über den Stromsensor fließende Laststrom aus dem über den ersten Messwiderstand fließenden Strom und/oder dem über den zweiten Messwiderstand fließenden Strom ermittelt.

Das Verfahren kann im zweiten Messzustand folgende Schritte aufweisen:

- der über den ersten Messwiderstand fließende Strom wird aus dem Spannungsabfall am ersten Messwiderstand und dem elektrischen Widerstand des ersten Messwiderstandes bestimmt und/oder
- der über den zweiten Messwiderstand fließende Strom wird aus dem Spannungsabfall am zweiten Messwiderstand und dem elektrischen Widerstand des zweiten Messwiderstandes bestimmt,
- der über den Referenzwiderstand fließende Strom wird aus dem Spannungsabfall am Referenzwiderstand und dem elektrischen Widerstand des Referenzwiderstandes bestimmt
- und anschließend wird der über den Stromsensor fließende Strom aus dem über den zweiten Messwiderstand fließenden Strom und/oder aus den addierten über den ersten Messwiderstand und den Referenzwiderstand fließenden Strömen ermittelt.

Die Spannungsabfälle am ersten Messwiderstand, am zweiten Messwiderstand und am Referenzwiderstand jeweils mit einer Spannungserfassungseinrichtung erfasst werden. Es erfolgt also eine direkte Erfassung der Spannungsabfälle.

Es ist aber auch möglich, einzelne Spannungsabfälle rechnerisch aus gemessenen Spannungsabfällen zu ermitteln. Beispielsweise kann zur Ermittlung des Spannungsabfalls am zweiten Messwiderstand der Spannungsabfall am ersten Messwiderstand sowie der Spannungsabfall am ersten Messwiderstand und am zweiten Messwiderstand, also der Gesamtspannungsabfall über den Stromsensor, erfasst werden und der Spannungsabfall am zweiten Messwiderstand aus der Differenz der erfassten Spannungsabfälle ermittelt werden.

Zusätzlich kann im ersten und/oder im zweiten Messzustand der Spannungsabfall zwischen dem ersten Anschluss und dem zweiten Anschluss erfasst werden. Der Spannungsabfall zwischen dem ersten Anschluss und dem zweiten Anschluss kann zum Abgleich der gemessenen Spannungsabfälle über den ersten Messwiderstand bzw. den ersten Messwiderstand und den Referenzwiderstand und dem Spannungsabfall über den zweiten Messwiderstand verwendet werden, so dass der die Genauigkeit der Messungen, insbesondere bei kleinen Strömen, verbessert werden kann.

Zur Lösung der Aufgabe ist des Weiteren ein Stromsensor zur Messung eines Batteriestroms, insbesondere einer Fahrzeugbatterie, vorgesehen, mit einem ersten Messwiderstand, einem zweiten Messwiderstand sowie einem Referenzwiderstand. Der erste Messwiderstand und der zweite Messwiderstand sind in Reihe zwischen einem ersten und einem zweiten Anschluss des Stromsensors angeordnet. Der Referenzwiderstand kann parallel zum ersten Messwiderstand geschaltet werden. Der Stromsensor hat des Weiteren eine erste Spannungserfassungseinrichtung zur Erfassung des Spannungsabfall über den ersten Messwiderstand, eine zweite Spannungserfassungseinrichtung zur Erfassung des Spannungsabfalls über den zweiten über Messwiderstand und eine Referenzwiderstand-Spannungserfassungseinrichtung zur Erfassung des Spannungsabfalls über den Referenzwiderstand sowie eine Auswerteschaltung zur Bestimmung des elektrischen Widerstandes des ersten und des zweiten Messwiderstandes mit einem vorstehend beschriebenen Verfahren.

Es sei erwähnt, dass die Reihenfolge der Messwiderstand in Stromrichtung bzw. zwischen den Anschlüssen beliebig variiert werden kann. Es ist lediglich erforderlich, dass ein erster und ein zweiter Messwiderstand in Reihe geschaltet sind und ein Referenzwiderstand zeitweise parallel zu einem der Messwiderstände geschaltet werden kann bzw. von diesen getrennt werden kann, sowie dass die Spannungsabfälle an den Widerständen jeweils einzeln, beispielsweise mit einer Spannungserfassungseinrichtung erfasst werden können.

Vorzugsweise ist ein Schaltelement vorgesehen, das in einer geschlossenen Stellung die Parallelschaltung des Referenzwiderstandes zum ersten Messwiderstand herstellt und in einer offenen Stellung den Referenzwiderstand vom ersten Messwiderstand trennt. Mit einem solchen Schaltelement kann der Referenzwiderstand auf einfache Weise zum ersten Messwiderstand parallel geschaltet oder von diesen getrennt werden.

Vorzugsweise sind die elektrischen Widerstände des ersten Messwiderstandes und des zweiten Messwiderstandes im Wesentlichen gleich groß.

Optional kann eine dritte Spannungserfassungseinrichtung zur Erfassung eines Spannungsabfalls über den ersten Messwiderstand und den zweiten Messwiderstand vorgesehen sein.

Die Messwiderstände können jeweils durch ein Widerstandselement gebildet sein. Es ist aber auch möglich, dass der erste Messwiderstand und/oder der zweite Messwiderstand zumindest zwei in Reihe und/oder parallel angeordnete Messwiderstandelemente aufweist.

Weitere Vorteile und Merkmale ergeben sich aus der nachfolgenden Beschreibung in Verbindung mit den beigefügten Zeichnungen. In diesen zeigen

Figur 1    eine erste Ausführungsform eines erfindungsgemäßen Stromsensors,

Figur 2    eine zweite Ausführungsform eines erfindungsgemäßen Stromsensors, und

Figur 3    eine dritte Ausführungsform eines erfindungsgemäßen Stromsensors.

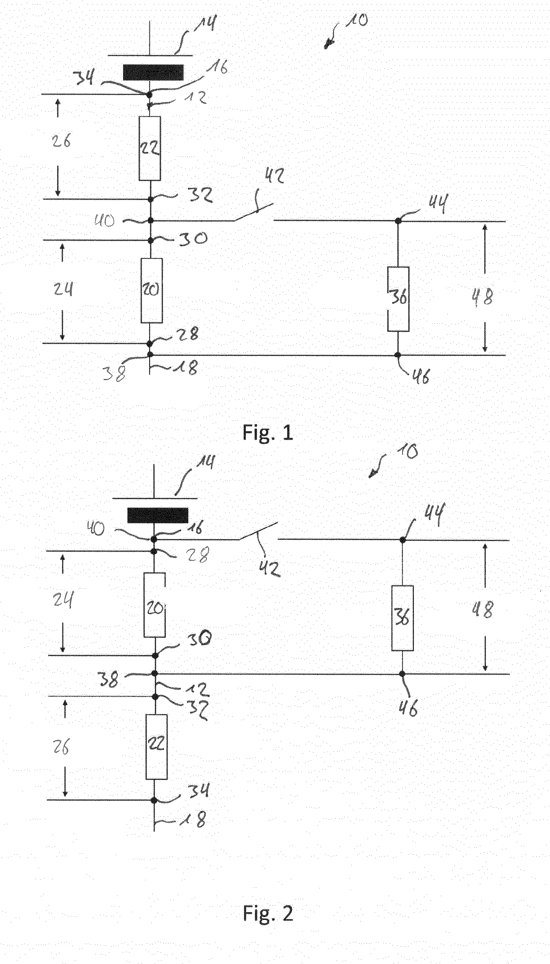

In Figur 1 ist ein Stromsensor 10 zu Bestimmung des Laststroms 12 an einer Fahrzeugbatterie 14 gezeigt. Der Stromsensor 10 wird beispielsweise verwendet, um den Ladungszustand oder den Gesundheitszustand der Fahrzeugbatterie 14 zu bestimmen.

Der Stromsensor 10 weist einen ersten Anschluss 16 auf, der mit der Fahrzeugbatterie kontaktiert werden kann, sowie einen zweiten Anschluss 18, der beispielsweise an der Fahrzeugkarosserie bzw. einer Masse kontaktiert wird. Der Stromsensor 10 wird so an die Fahrzeugbatterie 14 angeschlossen, dass der gesamte Laststrom über den Stromsensor 10 fließt und somit vom Stromsensor erfasst werden kann.

Der Stromsensor 10 hat einen ersten Messwiderstand 20 und einem zweiten Messwiderstand 22, die in Reihe zwischen dem ersten Anschluss 16 und dem zweiten Anschluss 18 angeordnet sind. Des Weiteren sind zwei Spannungserfassungseinrichtungen 24, 26 vorgesehen, die jeweils mit einer Anschlussstelle 28 30, 32, 34 vor und hinter den Messwiderständen 20,22 mit diesen elektrisch kontaktiert sind. Die erste Spannungserfassungseinrichtung 24 kann somit einen Spannungsabfall über den ersten Messwiderstand 20 erfassen, die zweite Spannungserfassungseinrichtung 26 kann einen Spannungsabfall über den zweiten Messwiderstand 22 erfassen.

Des Weiteren ist ein Referenzwiderstand 36 vorgesehen, der über zwei Anschlussstellen 38,40 parallel zum ersten Messwiderstand 20 geschaltet werden kann. Der Referenzwiderstand 36 ist ein hochgenauer Widerstand, der aus einem Material besteht, dass keine oder nur eine sehr geringe Änderung des elektrischen Widerstandes aufgrund von Temperatur, äußeren Einflüssen oder Alterung aufweist.

Am Referenzwiderstand 36 ist ein Schaltelement 42 vorgesehen, um die Verbindung zwischen dem Referenzwiderstand 36 und der Anschlussstelle 40 zu schließen oder zu unterbrechen. Über das Schaltelement 42 kann also der Referenzwiderstand 36 parallel zum ersten Messwiderstand 20 geschaltet werden oder von diesem getrennt werden.

Am Referenzwiderstand 36 ist des Weiteren eine über Anschlussstellen 44, 46 angeschlossene Referenzwiderstand-Spannungserfassungseinrichtung 48 zur Erfassung eines Spannungsabfalls über den Referenzwiderstand 36 vorgesehen.

Fließt über den Stromsensor 10 ein Laststrom 12, werden die Spannungsabfälle über den ersten bzw. den zweiten Messwiderstand 20, 22 erfasst und aus den erfassten Spannungsabfällen sowie den elektrischen Widerständen der Messwiderstände 20, 22 über das ohmsche Gesetz die Stromstärke des über den Stromsensor 10 fließenden Laststroms 12 bestimmt.

Aufgrund von Temperaturänderungen, äußeren Einflüssen oder durch Alterung kann es aber zu einer Veränderung des elektrischen Widerstandes der Messwiderstände 20, 22 kommen. Es ist daher erforderlich, während des Betriebes des Stromsensors 10 die elektrischen Widerstände der Messwiderstände 20, 22 bzw. Korrekturfaktoren zur Korrektur der elektrischen Widerstände der Messwiderstände 20, 22 zu bestimmen.

Dies erfolgt mit dem nachfolgend im Detail beschriebenen Verfahren.

Zunächst ist das Schaltelement 42 in einem ersten Schaltzustand geöffnet, so dass der Referenzwiderstand 36 vom ersten Messwiderstand 20 getrennt ist. In diesem Zustand kann auf die vorstehend beschriebene Weise der über den Stromsensor 10 fließende Laststrom 12 bestimmt werden. Aus den gemessenen Spannungsabfällen an den Messwiderständen 20, 22 kann das Verhältnis der elektrischen Widerstände R1, R2 des ersten Messwiderstandes 20 und des zweiten Messwiderstandes 22 berechnet werden.

Es gilt

$$a = R1/R2 = U2/U1$$

Anschließend wird in einem zweiten Messzustand das Schaltelement 42 geschlossen, so dass der Referenzwiderstand 36 parallel zum ersten Messwiderstand 20 geschaltet ist.

Zur Bestimmung des elektrischen Widerstandes des ersten Messwiderstandes 20 wird mit der zweiten Spannungserfassungseinrichtung 26 der Spannungsabfall über den zweiten Messwiderstand erfasst. Des Weiteren wird zeitgleich mit der ersten Spannungserfassungseinrichtung 24 der Spannungsabfall über den ersten Messwiderstand 20 erfasst. Zeitgleich wird über die Referenzwiderstand-Spannungserfassungseinrichtung 48 der Spannungsabfall am Referenzwiderstand 36 erfasst. Aus dem erfassten Spannungsabfall über den Referenzwiderstand 36 und dem bekannten elektrischen Widerstand des Referenzwiderstandes kann die Stromstärke Iref des über den Referenzwiderstand 36 fließenden Stroms bestimmt werden.

Im zweiten Messzustand fließt der gesamte Laststrom 12 über den zweiten Messwiderstand 22. Aufgrund der Parallelschaltung des ersten Messwiderstandes 20 und des Referenzwiderstandes 36 teilt sich der Laststrom auf die beiden Strompfade über den ersten Messwiderstand 20 und dem Referenzwiderstand 36 auf.

Es gilt also:

$$I = I2 = I1 + Iref$$

Aus I2 = U2/R2 und a= U2/U1 ergibt sich

$$I = U2/R2 = a*U2/R1$$

und

$$a*U2/R1 = U1/R1 + Iref$$

und

$$R1 = (a*U2-U1)/Iref$$

Es ist also nicht erforderlich, den elektrischen Widerstand des ersten oder des zweiten Messwiderstandes 20, 22 zu kennen. Es ist lediglich erforderlich, das vorab ermittelte Verhältnis der elektrischen Widerstände und des elektrischen Widerstand des Referenzwiederstandes 36 zu kennen sowie die Spannungsabfälle an den Messwiderständen 20, 22 sowie am Referenzwiderstand 36 zu messen.

Ist der elektrische Widerstand des ersten Messwiderstandes 20 bestimmt, wird im ersten Messzustand das Schaltelement 42 geöffnet, also der Referenzwiderstand 36 vom ersten Messwiderstand 20 getrennt. Der Laststrom fließt somit ausschließlich über den ersten Messwiderstand 20 und den zweiten Messwiderstand 22.

Anschließend wird über die Spannungserfassungseinrichtung 24 der Spannungsabfall über den ersten Messwiderstand 20 erfasst und aus dem Spannungsabfall sowie dem vorab bestimmten elektrischen Widerstand des ersten Messwiderstandes 20 die Stromstärke des Laststroms 12 bestimmt

Des Weiteren wird mit der zweiten Spannungserfassungseinrichtung 26 der Spannungsabfall über den zweiten Messwiderstand 22 erfasst. Da die Messwiderstände 20, 22 in Reihe angeordnet sind, stimmt die Stromstärke des über den zweiten Messwiderstand 22 fließenden Stroms mit der Stromstärke des über den ersten Messwiderstand 20 fließenden Stroms überein. Aus dem erfassten Spannungsabfall über den zweiten Messwiderstand 22 sowie der aus dem Spannungsabfall über das den ersten Messwiderstand 20 bestimmten Stromstärke kann somit über das ohmsche Gesetz der elektrische Widerstand des zweiten Messwiderstandes 22 bestimmt werden.

Der erstem Messzustand und der zweite Messzustand werden vorzugsweise wechselweise durchgeführt, so dass ein ständiger Abgleich der elektrischen Widerstände des ersten Messwiderstandes 20 und des zweiten Messwiderstandes 22 erfolgt. Insbesondere können durch den ständigen Abgleich die elektrischen Widerstände der Messwiderstände 20, 22 iterativ genauer bestimmt werden.

Der Vorteil des vorstehend beschriebenen Verfahrens liegt darin, dass permanent der gesamte Laststrom bzw. dessen Verlauf bestimmt wird, so dass Schwankungen im Laststrom bei der Bestimmung der elektrischen Widerstände der Messwiderstände 20, 22 berücksichtigt werden können.

Des Weiteren erfolgt stets eine Bestimmung des Laststroms aus dem Spannungsabfall am ersten und/oder am zweiten Messwiderstand 20, 22. Es erfolgt also eine unterbrechungsfreie Erfassung des Laststroms und gleichzeitig ein ständiger Abgleich der elektrischen Widerstände der Messwiderstände 20,22.

Für das vorstehend beschriebene Verfahren ist die Position des ersten Messwiderstandes 20, zu welchem der Referenzwiderstand 36 parallel geschaltet werden kann, in Stromrichtung unerheblich. Der erste Messwiderstand 20 kann, wie in Figur 1 dargestellt, der bezüglich der Stromrichtung S hintere Messwiderstand sein. Der erste Messwiderstand 20 kann aber auch, wie in Figur 2 dargestellt, der in Stromrichtung S vordere Messwiderstand sein.

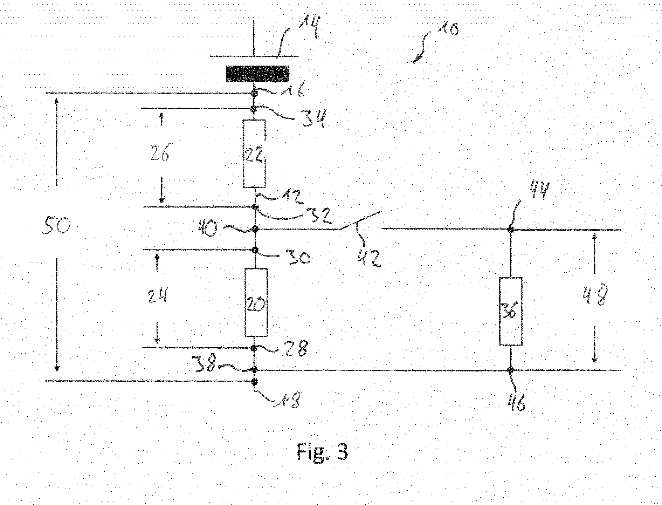

Der in Figur 3 dargestellte Stromsensor unterscheidet sich von dem in Figur 1 dargestellten Stromsensor lediglich durch eine zusätzliche Spannungserfassungseinrichtung 50, die den Spannungsabfall zwischen dem ersten Anschluss 16 und dem zweiten Anschluss 18, also den gesamten Spannungsabfall über den Stromsensor, erfasst.

Dieser Spannungsabfall kann zum Abgleich mit den vorstehend beschriebenen Spannungsabfällen bzw. zur Verbesserung der Bestimmung der Stromstärken an den einzelnen Messwiderständen 20,22 bzw. dem Referenzwiderstand 36 genutzt werden, und somit zu einer genaueren Bestimmung der elektrischen Widerstände der Messwiderstände 20, 22 verwendet werden.

Vorzugsweise sind die elektrischen Widerstände der Messwiderstände 20, 22 im Wesentlichen gleich groß. Diese können aber auch voneinander abweichen.

Das Schaltelement 42 kann durch beliebige elektrische Bauelemente gebildet sein. Alternativ kann das Schaltelement 42 die Verbindung zum Anschluss. 38 unterbrechen oder schließen. Es können auch zwei Schaltelemente 42 vorgesehen sein, die die Referenzwiderstand 36 vollständig vom Strompfad trennen.

Das vorstehend beschriebene Verfahren wird üblicherweise durch eine Steuerung ausgeführt, in der die elektrischen Widerstände der Messwiderstände 20,22 sowie des Referenzwiderstandes 36 gespeichert sind und die die beiden vorstehend beschriebenen Messzustände steuert.

**Bezugszeichenliste**

10   Stromsensor
12   Laststrom
14   Fahrzeugbatterie
16   erster Anschluss
18   zweiter Anschluss
20   erster Messwiderstand
22   zweiter Messwiderstand
24   erste Spannungserfassungseinrichtung
26   zweite Spannungserfassungseinrichtung
28   Anschlussstelle
30   Anschlussstelle
32   Anschlussstelle
34   Anschlussstelle
36   Referenzwiderstand
38   Anschlussstelle
40   Anschlussstelle
42   Schaltelement
44   Anschlussstelle
46   Anschlussstelle
48   Referenzwiderstand-Spannungserfassungseinrichtung
50   dritte Spannungserfassungseinrichtung

**Patentansprüche**

1.   Verfahren zum Betrieb eines Stromsensors (10), der einen ersten Messwiderstand (20), einen zweiten Messwiderstand (22) sowie einen Referenzwiderstand (36) aufweist, wobei der erste Messwiderstand (20) und der zweite Messwiderstand (22) in Reihe zwischen einem ersten Anschluss (16) und einem zweiten Anschluss (18) des Stromsensors (10) angeordnet sind, und wobei der Referenzwiderstand (36) in einem ersten Messzustand vom ersten Messwiderstand (20) und vom zweiten Messwiderstand (22) elektrisch getrennt ist und der Referenzwiderstand (36) in einem zweiten Messzustand elektrisch parallel zum ersten Messwiderstand (20) geschaltet ist, mit folgenden Schritten:

a) im ersten Messzustand Ermitteln des Spannungsabfalls am ersten Messwiderstand (20) und des Spannungsabfalls am zweiten Messwiderstand (22) und Bestimmen des Verhältnisses des Spannungsabfalls am ersten Messwiderstand (20) und des Spannungsabfalls am zweiten Messwiderstand (22),
b) im zweiten Messzustand Ermitteln des Spannungsabfalls am ersten Messwiderstand (20), des Spannungsabfalls am zweiten Messwiderstand (22) sowie des Spannungsabfalls am Referenzwiderstand (36) und Bestimmen des elektrischen Widerstandes des ersten Messwiderstandes (20) und Bestimmen des elektrischen Widerstandes des zweiten Messwiderstandes (22) aus den ermittelten Spannungsabfällen, dem elektrischen Widerstand des Referenzwiderstandes (36) und dem im ersten Messzustand bestimmten Verhältnis der Spannungsabfälle des ersten Messwiderstandes (20) und des zweiten Messwiderstandes (22).

2.   Verfahren nach Anspruch 1, **dadurch gekennzeichnet, dass** nach Schritt b) folgender Schritt durchgeführt wird:
c) Im ersten Messzustand Ermitteln des Spannungsabfalls am ersten Messwiderstand (20) und des Spannungsabfalls am zweiten Messwiderstand (22) und Bestimmen des Verhältnisses des Spannungsabfalls am ersten Messwiderstand (20) und des Spannungsabfalls am zweiten Messwiderstand (22) und Bestimmen des elektrischen Widerstandes des zweiten Messwiderstandes (22) aus den ermittelten Spannungsabfällen am ersten Messwiderstand (20) und am zweiten Messwiderstand (22) und dem in Schritt b) ermittelten elektrischen Widerstandes des ersten Messwiderstandes (20).

3.   Verfahren nach Anspruch 2, **dadurch gekennzeichnet, dass** die Schritte b) und c) wechselweise wiederholt werden.

4.   Verfahren nach einem der vorhergehenden Ansprüche, **dadurch gekennzeichnet, dass** vor Schritt a) der elektrische Widerstand des ersten Messwiderstandes (20) bestimmt wird.

5.   Verfahren nach einem der vorhergehenden Ansprüche, **dadurch gekennzeichnet, dass** im ersten Messzustand

- der über den ersten Messwiderstand fließende Strom aus dem Spannungsabfall am ersten Messwiderstand (20) und dem elektrischen Widerstand des ersten Messwiderstandes bestimmt wird und/oder
- der über den zweiten Messwiderstand fließende Strom aus dem Spannungsabfall am zweiten Messwiderstand (22) und dem elektrischen Widerstand des zweiten Messwiderstandes (22) bestimmt wird und anschließend
- der über den Stromsensor fließende Laststrom aus dem über den ersten Messwiderstand fließenden Strom und/oder dem über den zweiten Messwiderstand fließenden Strom ermittelt wird.

6.   Verfahren nach einem der vorhergehenden Ansprüche, **dadurch gekennzeichnet, dass** im zweiten Messzustand

- der über den ersten Messwiderstand fließende Strom aus dem Spannungsabfall am ersten Messwiderstand (20) und dem elektrischen Widerstand des ersten Messwiderstandes (20) bestimmt wird und/oder
- der über den zweiten Messwiderstand fließende Strom aus dem Spannungsabfall am zweiten Messwiderstand (22) und dem elektrischen Widerstand des zweiten Messwiderstandes (22) bestimmt wird,
- der über den Referenzwiderstand fließende Strom aus dem Spannungsabfall am Referenzwiderstand (36) und dem elektrischen Widerstand des Referenzwiderstandes (36) bestimmt wird und anschließend
- der über den Stromsensor fließende Strom aus dem über den zweiten Messwiderstand (22) fließenden Strom und/oder aus den addierten über den ersten Messwiderstand (20) und den Referenzwiderstand (36) fließenden Strömen ermittelt wird.

7. Verfahren nach einem der vorhergehenden Ansprüche, **dadurch gekennzeichnet, dass** die Spannungsabfälle am ersten Messwiderstand (20), am zweiten Messwiderstand (22) und am Referenzwiderstand (36) jeweils mit einer Spannungserfassungseinrichtung (24, 26, 48) erfasst werden.

8. Verfahren nach einem der vorhergehenden Ansprüche, **dadurch gekennzeichnet, dass** zur Ermittlung des Spannungsabfalls am zweiten Messwiderstand (22) der Spannungsabfall am ersten Messwiderstand (20) sowie der Spannungsabfall am ersten Messwiderstand (20) und am zweiten Messwiderstand (22) erfasst werden und der Spannungsabfall am zweiten Messwiderstand (22) aus der Differenz der erfassten Spannungsabfälle ermittelt wird.

9. Stromsensor (10) zur Messung eines Batteriestroms (12), insbesondere einer Fahrzeugbatterie (14), mit einem ersten Messwiderstand (20), einem zweiten Messwiderstand (22) und einem Referenzwiderstand (36), wobei der erste Messwiderstand (20) und der zweite Messwiderstand (22) in Reihe zwischen einem ersten Anschluss (16) und einem zweiten Anschluss (18) des Stromsensors (10) angeordnet sind, und wobei der Referenzwiderstand (36) in einem ersten Messzustand vom ersten Messwiderstand (20) und vom zweiten Messwiderstand (22) elektrisch getrennt ist und der Referenzwiderstand (36) in einem zweiten Messzustand elektrisch parallel zum ersten Messwiderstand (20) geschaltet ist, mit Spannungserfassungseinrichtungen (24, 26, 48, 50) zur Ermittlung der Spannungsabfälle am ersten Messwiderstand (20), am zweiten Messwiderstand (22) und am Referenzwiderstand (36), und mit einer Steuerung zur Bestimmung des elektrischen Widerstandes des ersten Messwiderstandes (20) und des zweiten Messwiderstandes (22) mit einem Verfahren nach einem der vorhergehenden Ansprüche.

10. Stromsensor nach Anspruch 9, **dadurch gekennzeichnet, dass** ein Schaltelement (42) vorgesehen ist, das in einer geschlossenen Stellung die Parallelschaltung des Referenzwiderstandes (36) zum ersten Messwiderstand (20) herstellt.

11. Stromsensor nach einem der Ansprüche 9 und 10, **dadurch gekennzeichnet, dass** eine erste Spannungserfassungseinrichtung (24) zur Erfassung eines Spannungsabfalls am ersten Messwiderstand (20) und/oder eine zweite Spannungserfassungseinrichtung (26) zur Erfassung eines Spannungsabfalls am zweiten Messwiderstand (22) vorgesehen ist, und dass eine Referenzstrom-Spannungserfassungseinrichtung (48) zur Erfassung eines Spannungsabfalls am Referenzwiderstand (36) vorgesehen ist.

12. Stromsensor nach einem der Ansprüche 9 bis 11, **dadurch gekennzeichnet, dass** eine dritte Spannungserfassungseinrichtung (50) zur Erfassung eines Spannungsabfalls über den ersten Messwiderstand (2) und den zweiten Messwiderstand (22) vorgesehen ist.

13. Stromsensor nach einem der Ansprüche 9 bis 12, **dadurch gekennzeichnet, dass** die elektrischen Widerstände des ersten Messwiderstandes (20) und des zweiten Messwiderstandes (22) im Wesentlichen gleich groß sind.

**Claims**

1. Method for operating a current sensor (10), which has a first measurement resistor (20), a second measurement resistor (22) and also a reference resistor (36), wherein the first measurement resistor (20) and the second measurement resistor (22) are arranged in series between a first connection (16) and a second connection (18) of the current sensor (10), and wherein the reference resistor (36) is electrically disconnected from the first measurement resistor (20) and from the second measurement resistor (22) in a first measurement state and the reference resistor (36) is electrically connected in parallel with the first measurement resistor (20) in a second measurement state, comprising the following steps:

    a) in the first measurement state, identifying the voltage drop at the first measurement resistor (20) and the voltage drop at the second measurement resistor (22) and determining the ratio of the voltage drop at the first measurement resistor (20) and the voltage drop at the second measurement resistor (22),

b) in the second measurement state, identifying the voltage drop at the first measurement resistor (20), the voltage drop at the second measurement resistor (22) and also the voltage drop at the reference resistor (36) and determining the electrical resistance of the first measurement resistor (20) and determining the electrical resistance of the second measurement resistor (22) from the identified voltage drops, the electrical resistance of the reference resistor (36) and the ratio of the voltage drops of the first measurement resistor (20) and the second measurement resistor (22) determined in the first measurement state.

2. Method according to Claim 1, **characterized in that** the following step is carried out after step b):

c) in the first measurement state, identifying the voltage drop at the first measurement resistor (20) and the voltage drop at the second measurement resistor (22) and determining the ratio of the voltage drop at the first measurement resistor (20) and the voltage drop at the second measurement resistor (22) and determining the electrical resistance of the second measurement resistor (22) from the identified voltage drops at the first measurement resistor (20) and at the second measurement resistor (22) and the electrical resistance of the first measurement resistor (20) identified in step b).

3. Method according to Claim 2, **characterized in that** steps b) and c) are carried out repeatedly in alternation.

4. Method according to one of the preceding claims, **characterized in that** the electrical resistance of the first measurement resistor (20) is determined before step a).

5. Method according to one of the preceding claims, **characterized in that**, in the first measurement state:

   - the current flowing across the first measurement resistor is determined from the voltage drop at the first measurement resistor (20) and the electrical resistance of the first measurement resistor
   and/or
   - the current flowing across the second measurement resistor is determined from the voltage drop at the second measurement resistor (22) and the electrical resistance of the second measurement resistor (22) and subsequently
   - the load current flowing across the current sensor is identified from the current flowing across the first measurement resistor and/or the current flowing across the second measurement resistor.

6. Method according to one of the preceding claims, **characterized in that**, in the second measurement state:

   - the current flowing across the first measurement resistor is determined from the voltage drop at the first measurement resistor (20) and the electrical resistance of the first measurement resistor (20) and/or
   - the current flowing across the second measurement resistor is determined from the voltage drop at the second measurement resistor (22) and the electrical resistance of the second measurement resistor (22),
   - the current flowing across the reference resistor is determined from the voltage drop at the reference resistor (36) and the electrical resistance of the reference resistor (36)
   and subsequently
   - the current flowing across the current sensor is identified from the current flowing across the second measurement resistor (22) and/or from the added currents flowing across the first measurement resistor (20) and the reference resistor (36).

7. Method according to one of the preceding claims, **characterized in that** the voltage drops at the first measurement resistor (20), at the second measurement resistor (22) and at the reference resistor (36) are each detected by way of a voltage detection device (24, 26, 48).

8. Method according to one of the preceding claims, **characterized in that**, to identify the voltage drop at the second measurement resistor (22), the voltage drop at the first measurement resistor (20) and the voltage drop at the first measurement resistor (20) and at the second measurement resistor (22) are detected and the voltage drop at the second measurement resistor (22) is identified from the difference between the detected voltage drops.

9. Current sensor (10) for measuring a battery current (12), in particular of a vehicle battery (14), having a first measurement resistor (20), a second measurement resistor (22) and a reference resistor (36), wherein the first measurement resistor (20) and the second measurement resistor (22) are arranged in series between a first connection (16) and a second connection (18) of the current sensor (10), and wherein the reference resistor (36) is electrically disconnected from the first measurement resistor (20) and from the second measurement resistor (22) in a first measurement state and the reference resistor (36) is electrically connected in parallel with the first measurement resistor (20) in a second measurement state, having voltage detection devices (24, 26, 48, 50) for identifying the voltage drops at the first measurement resistor (20), at the second measurement resistor (22) and at the reference resistor (36), and having a control system for determining the electrical resistance of the first measurement resistor (20) and the second measurement resistor (22) by way of a method according to one of the preceding claims.

10. Current sensor according to Claim 9, **characterized in that** a switching element (42) is provided, said switching element in a closed position producing the parallel circuit of the reference resistor (36) with the first measurement resistor (20).

11. Current sensor according to one of Claims 9 and 10, **characterized in that** a first voltage detection device (24) is provided to detect a voltage drop at the first measurement resistor (20) and/or a second voltage detection device (26) is provided to detect a voltage drop at the second measurement resistor (22), and **in that** a reference current voltage detection device (48) is provided to detect a voltage drop at the reference resistor (36).

12. Current sensor according to one of Claims 9 to 11, **characterized in that** a third voltage detection device (50) is provided to detect a voltage drop across the first measurement resistor (20) and the second measurement resistor (22).

13. Current sensor according to one of Claims 9 to 12, **characterized in that** the electrical resistances of the first measurement resistor (20) and of the second measurement resistor (22) are substantially the same.

**Revendications**

1. Procédé permettant de faire fonctionner un capteur de courant (10) qui présente une première résistance de mesure (20), une deuxième résistance de mesure (22) ainsi qu'une résistance de référence (36), dans lequel la première résistance de mesure (20) et la deuxième résistance de mesure (22) sont disposées en série entre une première borne (16) et une deuxième borne (18) du capteur de courant (10), et dans lequel la résistance de référence (36) dans un premier état de mesure est électriquement isolée de la première résistance de mesure (20) et de la deuxième résistance de mesure (22), et la résistance de référence (36) dans un deuxième état de mesure est connectée électriquement en parallèle à la première résistance de mesure (20), comprenant les étapes suivantes consistant à :

a) dans le premier état de mesure, établir la chute de tension au niveau de la première résistance de mesure (20) et la chute de tension au niveau de la deuxième résistance de mesure (22), et déterminer le rapport entre la chute de tension au niveau de la première résistance de mesure (20) et la chute de tension au niveau de la deuxième résistance de mesure (22),
b) dans le deuxième état de mesure, établir la chute de tension au niveau de la première résistance de mesure (20), la chute de tension au niveau de la deuxième résistance de mesure (22) ainsi que la chute de tension au niveau de la résistance de référence (36), et déterminer la résistance électrique de la première résistance de mesure (20) et déterminer la résistance électrique de la deuxième résistance de mesure (22) à partir des chutes de tension établies, de la résistance électrique de la résistance de référence (36) et du rapport entre les chutes de tension de la première résistance de mesure (20) et de la deuxième résistance de mesure (22), déterminé dans le premier état de mesure.

2. Procédé selon la revendication 1, **caractérisé en ce qu'**après l'étape b), l'étape suivante est exécutée :
c) dans le premier état de mesure, établir la chute de tension au niveau de la première résistance de mesure (20) et la chute de tension au niveau de la deuxième résistance de mesure (22), et déterminer le rapport entre la chute de tension au niveau de la première résistance de mesure (20) et la chute de tension au niveau de la deuxième résistance de mesure (22), et déterminer la résistance électrique de la deuxième résistance de mesure (22) à partir des chutes de tension établies au niveau de la première résistance de mesure (20) et au niveau de la deuxième résistance de mesure (22) et de la résistance électrique de la première résistance de mesure (20) établie à l'étape b).

3. Procédé selon la revendication 2, **caractérisé en ce que** les étapes b) et c) sont répétées en alternance.

4. Procédé selon l'une quelconque des revendications précédentes, **caractérisé en ce qu'**avant l'étape a), la résistance électrique de la première résistance de mesure (20) est déterminée.

5. Procédé selon l'une quelconque des revendications précédentes, **caractérisé en ce que** dans le premier état de mesure

- le courant passant par la première résistance de mesure est déterminé à partir de la chute de tension au niveau de la première résistance de mesure (20) et de la résistance électrique de la première résistance de mesure, et/ou

- le courant passant par la deuxième résistance de mesure est déterminé à partir de la chute de tension au niveau de la deuxième résistance de mesure (22) et de la résistance électrique de la deuxième résistance de mesure (22), et ensuite

- le courant de charge passant par le capteur de courant est établi à partir du courant passant par la première résistance de mesure et/ou du courant passant par la deuxième résistance de mesure.

**6.** Procédé selon l'une quelconque des revendications précédentes, **caractérisé en ce que** dans le deuxième état de mesure

- le courant passant par la première résistance de mesure est déterminé à partir de la chute de tension au niveau de la première résistance de mesure (20) et de la résistance électrique de la première résistance de mesure (20), et/ou

- le courant passant par la deuxième résistance de mesure est déterminé à partir de la chute de tension au niveau de la deuxième résistance de mesure (22) et de la résistance électrique de la deuxième résistance de mesure (22),

- le courant passant par la résistance de référence est déterminé à partir de la chute de tension au niveau de la résistance de référence (36) et de la résistance électrique de la résistance de référence (36), et ensuite

- le courant passant par le capteur de courant est établi à partir du courant passant par la deuxième résistance de mesure (22) et/ou des courants passant par la première résistance de mesure (20) et la résistance de référence (36) additionnés.

**7.** Procédé selon l'une quelconque des revendications précédentes, **caractérisé en ce que** les chutes de tension au niveau de la première résistance de mesure (20), de la deuxième résistance de mesure (22) et de la résistance de référence (36) sont respectivement détectées à l'aide d'un dispositif de détection de tension (24, 26, 48).

**8.** Procédé selon l'une quelconque des revendications précédentes, **caractérisé en ce que** pour l'établissement de la chute de tension au niveau de la deuxième résistance de mesure (22), la chute de tension au niveau de la première résistance de mesure (20) ainsi que la chute de tension au niveau de la première résistance de mesure (20) et de la deuxième résistance de mesure (22) sont détectées, et la chute de tension au niveau de la deuxième résistance de mesure (22) est établie à partir de la différence entre les chutes de tension établies.

**9.** Capteur de courant (10) permettant de mesurer un courant de batterie (12), en particulier d'une batterie de véhicule (14), comprenant une première résistance de mesure (20), une deuxième résistance de mesure (22) et une résistance de référence (36), dans lequel la première résistance de mesure (20) et la deuxième résistance de mesure (22) sont disposées en série entre une première borne (16) et une deuxième borne (18) du capteur de courant (10), et dans lequel la résistance de référence (36) dans un premier état de mesure est isolée électriquement de la première résistance de mesure (20) et de la deuxième résistance de mesure (22), et la résistance de référence (36) dans un deuxième état de mesure est connectée électriquement en parallèle à la première résistance de mesure (20), comprenant des dispositifs de détection de tension (24, 26, 48, 50) pour établir les chutes de tension au niveau de la première résistance de mesure (20), de la deuxième résistance de mesure (22) et de la résistance de référence (36), et comprenant une commande pour déterminer la résistance électrique de la première résistance de mesure (20) et de la deuxième résistance de mesure (22) à l'aide d'un procédé selon l'une quelconque des revendications précédentes.

**10.** Capteur de courant selon la revendication 9, **caractérisé en ce qu'**un élément de commutation (42) est prévu qui établit dans une position fermée la connexion parallèle de la résistance de référence (36) à la première résistance de mesure (20).

**11.** Capteur de courant selon l'une quelconque des revendications 9 et 10, **caractérisé en ce qu'**un premier dispositif de détection de tension (24) est prévu pour détecter une chute de tension au niveau de la première résistance de mesure (20) et/ou un deuxième dispositif de détection de tension (26) est prévu pour détecter une chute de tension au niveau de la deuxième résistance de mesure (22), et **en ce qu'**un dispositif de détection de tension de courant de référence (48) est prévu pour détecter une chute de tension au niveau de la résistance de référence (36).

**12.** Capteur de courant selon l'une quelconque des revendications 9 à 11, **caractérisé en ce qu'**un troisième dispositif de détection de tension (50) est prévu pour détecter une chute de tension aux bornes de la première résistance de mesure (2) et de la deuxième résistance de mesure (22).

**13.** Capteur de courant selon l'une quelconque des revendications 9 à 12, **caractérisé en ce que** les résistances électriques de la première résistance de mesure (20) et de la deuxième résistance de mesure (22) sont substantiellement égales.

Fig. 1

Fig. 2

Fig. 3

EP 3 640 651 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2546664 A2